# EUROPÄISCHE PATENTSCHRIFT

(11) **EP 1 005 263 B1**
(45) Veröffentlichungstag und Bekanntmachung des Hinweises auf die Patenterteilung: **11.05.2005**
(21) Anmeldenummer: 99123094.7
(22) Anmeldetag: 22.11.1999
(51) Int. Cl.: H05K 5/02, H02B 1/04

(54) **Befestigungsvorrichtung für ein elektronisches Gerät oder dessen Tragrahmen in einem Frontplatten-Ausschnitt**
Fastening device for an electronic apparatus or its supporting frame in a front plate opening
Dispositif de fixation d'un appareil électronique, ou son cadre-support dans l'ouverture d'une façade

(30) Priorität: 23.11.1998 DE 19853918
(43) Veröffentlichungstag der Anmeldung: 31.05.2000
(73) Patentinhaber: VIPA Gesellschaft für Visualisierung und Prozessautomatisierung m.b.H., 91074 Herzogenaurach (DE); Seel, Wolfgang, 90419 Nürnberg (DE)
(72) Erfinder: Seel, Wolfgang, 90419 Nürnberg (DE)
(74) Vertreter: Dreykorn-Lindner, Werner, Dipl.-Ing.

(56) Entgegenhaltungen:
- EP-A- 0 154 782
- DE-A- 2 619 340
- DE-A- 2 905 317
- DE-A- 3 600 471
- DE-A- 3 605 143
- DE-A- 3 609 424
- DE-A- 3 615 552
- DE-A- 3 621 262
- DE-A- 3 710 736
- DE-A- 4 231 827
- DE-U- 1 700 201
- DE-U- 1 897 975
- DE-U- 7 624 442
- DE-U- 29 519 019
- DE-U- 29 717 609
- FR-A- 2 602 288

## Beschreibung

Die Erfindung geht aus von einer Befestigungsvorrichtung für ein elektronisches Gerät oder dessen Tragrahmen in einem Frontplatten-Ausschnitt.

Befestigungsvorrichtungen der eingangs genannten Art werden häufig zur Halterung von Leiterplatten bzw. Schaltungsplatten, Displays o.ä. eingesetzt. Bei elektronischen Displays sind vor allem Anforderungen für eine exakte Ausrichtung sowie für einen sicheren Halt im eingebautem Zustand zu erfüllen.

Beispielsweise ist aus der DE 36 00 471 C2 eine Befestigungsvorrichtung für ein elektronisches Display bekannt, bei dem das plattenförmige elektronische Display auf einem ebenen, plattenförmigen Halter angebracht und mittels Tragelementen auf einer Platte, insbesondere einer Leiterplatte, befestigt ist. Weiterhin ist wenigstens ein von einer Seite des plattenförmigen Halters ausgehendes, in Anlage mit einer Seite des elektronischen Displays bringbares Positionierglied vorgesehen, wobei an der gegenüber dem Positionierglied entgegengesetzten Seite Klemmglieder angeordnet sind. Im einzelnen weist die Befestigungsvorrichtung integral mit gegenüberliegenden Seiten des plattenförmigen Halters mittels flexibler Kuppelstücke verbundene, umbiegbare, das auf dem Halter angebrachte Display festhaltende Befestigungsglieder auf. Weiterhin sind an den Befestigungsgliedern angebrachte und in Eingriff mit Halteelementen am plattenförmigen Halter bringbare, die umgebogenen Befestigungsglieder fixierende Halteelemente vorgesehen. Die Klemmglieder sind an den Befestigungsgliedern angebracht, wobei die Klemmglieder bei umgebogenen Befestigungsgliedern in Anpressanlage mit den Enden des elektronischen Display stehen.

Ferner ist aus der DE 36 09 424 C2 eine Haltevorrichtung für ein elektronisches Display mit einem ebenen und plattenförmigen, ein plattenförmiges elektronisches Display aufnehmenden Träger bekannt. Dabei ist eine mit einer Anschlüsse des elektronischen Displays aufnehmenden, an einem Kantenbereich des plattenförmigen Trägers angeformten Anschlusshalterung vorgesehen, welche eine Vielzahl von Einführungsschlitzen aufweist, die an ihren displayseitigen Einsteckbereichen verbreitert und an ihren entgegengesetzten Bereichen verengt sind. Eine ebene Fläche des plattenförmigen Trägers ist - zur Befestigung des elektronischen Displays im montierten Zustand - im wesentlichen parallel zu einer Leiterplatte in einem vorgesehenen Abstand angeordnet und die Einführungsschlitze verlaufen im wesentlichen senkrecht dazu. Im einzelnen sind den plattenförmigen Träger auf der Leiterplatte festhaltende und positionierende Befestigungsglieder vorgesehen, wobei sich die Anschlusshalterung und die Einführungsschlitze vom Kantenbereich aus ganz zur Leiterplatte hin erstrecken und die verengten Bereiche der Einführungsschlitze zur Ausrichtung der Anschlüsse auf Kontaktlöcher der Leiterplatte ausgebildet sind. Die seitlich offene Gestaltung der geschlitzten Anschlusshalterung gestattet eine Versetzung des Trägers nach Einführung der Anschlüsse.

Eine weitere alternative Ausführungsform ist bei der Befestigungsvorrichtung gemäß der DE 36 15 552 C2 beschrieben, welche von der Rückseite des plattenförmigen Halters ausgehende Fixierglieder, zur Fixierung des plattenförmigen Halters auf einer Leiterplatte, aufweist. Im einzelnen sind sich von den gegenüberliegenden Längsseiten des plattenförmigen Halters aus erstreckende, den Kantenbereich des elektronischen Displays festhaltende Halteglieder sowie ein Paar von Befestigungsgliedern vorgesehen, die aus an wenigstens einem der Halteglieder oder am plattenförmigen Halter angeformten Vorsprüngen sowie Aufnahmeöffnungen zur Aufnahme dieser Vorsprünge bestehen. Schließlich weist die Befestigungsvorrichtung Einrückglieder zur Fixierung der schwenkbaren Halteglieder auf dem plattenförmigen Halter und zur Verrastung in einer das elektronische Display festhaltenden Position auf.

Eine Weiterbildung der vorstehend beschriebenen Halte- bzw. Befestigungsvorrichtungen ist aus der DE 36 21 262 C2 bekannt. Bei dieser Haltevorrichtung wird von mit sich von der Rückseite des plattenförmigen Trägers aus erstreckenden, diesen auf einer Leiterplatte fixierenden Fixiergliedern und mit wenigstens zwei schwenkbar über Gelenke am plattenförmigen Träger zur Befestigung eines elektronischen Displays angebrachten Haltegliedern ausgegangen. Die Halteglieder übergreifen in der Befestigungsposition jeweils das elektronische Display und verrasten mit dem plattenförmigen Träger mittels lösbarer Rastglieder. Im einzelnen sind die Gelenke an den beiden Endbereichen einer der beiden Längskanten des Trägers angeformt. Weiterhin ist an den freien Enden der Halteglieder jeweils nur ein Rastglied angeordnet, das mit dem am entsprechenden Endbereich der gegenüberliegenden Längskante des Trägers angeordneten Rastglied jeweils verrastbar ist.

Solche speziellen Halte- bzw. Befestigungsvorrichtungen ermöglichen zwar die leichte Demontage des elektronischen Displays bei Defekt, sind jedoch konstruktiv sehr aufwendig und nur für den vorbestimmten Einsatzfall geeignet.

Neben diesen speziellen Halte- bzw. Befestigungsvorrichtungen sind auch Haltevorrichtungen basierend auf Federrastverbindungen bekannt. So ist beispielsweise beim Gegenstand der DE 36 05 143 A1 ein Haltebügel zur Befestigung von flachen Bauteilen, insbesondere von Schaltungsplatten oder Displays an einem Gehäuseteil beschrieben, welcher winkelförmig gestaltet ist, wobei sein einer Schenkel innerhalb einer schachtartigen Aufnahme im Gehäuseteil verrastet und sich teilweise an einer Wandung des Gehäuseteils abstützt, während der andere Schenkel unter Vorspannung an dem flachen Bauteil zur Anlage gelangt. Zum Erzielen der Vorspannung ist der Winkel zwischen beiden Schenkeln kleiner als 90°, wobei der am Bauteil anliegende Schenkel in seinem dem Bauteil zugewandten Endbereich einen Ansatz runder oder balliger Kontur besitzt. Um ein zu weites Auffedern der Schenkel beim Befestigungsvorgang bzw. beim Lösen mittels Schraubendreher zu verhindern, ist im Verbindungsbereich der beiden Schenkel eine Versteifungsrippe angeordnet. Ein solcher Haltebügel mit festen Abmessungen weist den Nachteil auf, dass dieser nicht an unterschiedliche Wandstärken des Gehäuseteils bzw. Höhen des Displays anpaßbar ist und dass der Endbereich des einen Schenkels von der Frontseite sichtbar ist.

Ein weiteres Beispiel für eine Drehfeder-Rastverbindung zeigt die G 91 09 166.7. Dabei wird von einer Einrichtung zum Befestigen eines LC-Displays auf einer Leiterplatte ausgegangen, welche aus dem LC-Display, der Leiterplatte, einem Rahmen mit inliegenden Leitgummistreifen, einem Gehäuse und mehreren an der Schnittkante des Gehäuses angeordneten Befestigungselementen zur Rastverbindung des LC-Displays mit der Leiterplatte besteht. Im einzelnen ist das Befestigungselement in Form einer Drehfeder-Rastverbindung ausgestaltet, mit einem Dreh-Federbereich und mit zwei mit diesem verbundenen Flügeln, deren Flächen, bezogen auf die Seitenfläche des Gehäuses, nach unten schräg verlaufen und welche beim Befestigen um eine Drehachse des Dreh-Federbereichs im gleichen Drehsinn gedreht werden

Aus dem G 88 09 196.1 ist ein Halter bekannt, welcher zur Befestigung eines von einem Halterahmen umgebenen Displays an einem Gehäuseoberteil einer Fernsprechstation dient. Dieser ist im wesentlichen U-förmig gestaltet und weist in seinem Basisbereich eine Ausnehmung auf, in der ein in seinem jeweiligen Endbereich Ansätze aufweisender Steg schwenkbar gelagert ist. Weiterhin sind senkrecht zum Basisbereich verlaufende kurze Nasen vorgesehen, welche nach Befestigung des Halters, den das Display aufnehmenden Rahmen fest an das Gehäuseoberteil pressen.

Weiterhin ist aus dem DE 295 19 019 U1 ein elektronisches Gerät mit einem Gehäuse bekannt, das zur Befestigung in einem geeigneten Ausschnitt einer Platte, z.B. einer Schranktür oder einer Schalttafel, ein Gehäusevorderteil mit einem der Vorderseite des Gehäuses benachbarten Rand aufweist, der in einer Ebene verläuft und die hinteren Seitenwände sowie die Rückwand des Gehäuses seitlich überragt. Um mit geringem konstruktivem Aufwand das elektronische Gerät in den Ausschnitt von vom her einzuschieben und zu befestigen, ist im einzelnen zumindest ein Verriegelungselement vorgesehen, das hinter dem Ausschnittrand an den Seitenwänden des Gehäuses befestigbar ist, diese im befestigten Zustand wie der Rand des Gehäusevorderteils seitlich überragt und eine Durchbrechung aufweist, in welcher ein in Richtung zur Rückseite des Ausschnittrands bewegliches Andrückmittel gehalten wird.

Das elektronische Gerät wird mit der Rückwand voran in den Ausschnitt eingeschoben, bis der umlaufende Rand, der in einer Ebene verläuft und mit einer Dichtung zum Schutz gegen Feuchtigkeit und Schmutz versehen sein kann, auf dem Rand des Ausschnitts aufliegt. In dieser Lage wird das elektronische Gerät mit vier Verriegelungselementen gesichert.

Zur einfachen Befestigung des Verriegelungselements ist es in seinem vorderen Bereich mit einer Schwalbenschwanzpassung versehen, mit der es in eine entsprechende Führung an der Kante des Gehäuses einfügbar ist, und besitzt an einem aus der Führungsnut herausragenden Fortsatz eine Rastnase, die in einer Rastöffnung in der Endlage einrastet. Das Verriegelungselement trägt in einer Gewindebohrung eine Schraube, die sich bei Eindrehen im eingebauten Zustand an die Rückseite des Ausschnittrands andrückt. Die Schraube wird vorzugsweise selbsthemmend in der Gewindebohrung gehalten. Alternativ kann ein mit Rastnuten versehener Stab verwendet werden, der durch eine dazu korrespondierende Öffnung mit Rastnasen am Verriegelungselement gegen die Rückseite des Ausschnittrands geschoben wird. Der Rand wird durch die Andrückkraft der Schraube an den Ausschnittrand angedrückt und schließt mit seiner Gummidichtung dichtend ab. Das Verriegelungselement wurde von hinten in seine Führungsnut eingesteckt, ragt nun wie der Rand seitlich über die Seitenwände und hinaus und hintergreift den Ausschnittrand der Platte. Zum Ausbau des elektronischen Geräts wird die Schraube gelöst, der Fortsatz vom Gehäuse zur Entriegelung der Rastverbindung weggebogen und das Verriegelungselement, welches beispielsweise als Kunststoffspritzgußteil hergestellt ist, aus seiner Führungsnut gezogen.

Probleme mit einer solchen Befestigungsvorrichtung ergeben sich in der Praxis, wenn der Einbauraum beengt ist, insbesondere die jeweilige Ecke des Gehäuses seitlich nicht einen entsprechenden Freiraum aufweist. Zudem setzt diese Art des Verriegelungselements eine gewisse Biegeeleastizität voraus, welche gerade bei der Benutzung eines Kunststoffspritzteils und häufigem Ein- und Ausbau zur Beschädigung führen kann. Auch kann es zu Schwierigkeiten beim Einstecken des Verriegelungselements kommen, da die Einrastung nur bei positionsgenauer Lage erfolgt.

Eine ähnliche Ausgestaltung einer Vorrichtung zur Befestigung einer Display-Baugruppe in einem Frontplatten- oder Schalttafel-Ausschnitt, mit einem von der Vorderseite in den Frontplatten- oder Schalttafel-Ausschnitt einsetzbaren Montagerahmen, und mit Mitteln zur Befestigung der Display-Baugruppe an dem Montagerahmen ist aus der G 87 03 149.3 bekannt. Im einzelnen weist der Montagerahmen an wenigstens zwei seiner äusseren sich gegenüberliegenden Umfangsränder Verankerungsausnehmungen auf. Weiters ist ein aus drei Abschnitten bestehendes Trägerteil vorgesehen, welches den Verankerungsausnehmungen zugeordnete Verankerungsvorsprünge aufweist, die an zwei sich gegenüberliegenden verschwenkbar ausgebildeten Seitenteilen wie das Trägerteil ausgebildet sind, wobei das Trägerteil über die Verankerungsvorsprünge der Seitenteile von der Rückseite der Frontplatte bzw. Schalttafel her an dem Montagerahmen verankerbar ist. Schließlich sind die Seitenteile zur Halterung der Display-Baugruppe ausgebildet, wobei sie zur Halterung der Display-Baugruppe eine Schwenklage einnehmen, in welcher die Seitenteile im wesentlichen senkrecht zum Mittelteil des Trägerteils verlaufen. Das Trägerteil ist so ausgebildet, dass Abschnitte elastisch verformt werden können, um dadurch eine Rastverbindung mit dem Montagerahmen herzustellen. Die Display-Baugruppe kann nach Herstellung dieser Rastverbindung zwischen Trägerteil und Montagerahmen in das Trägerteil eingesetzt werden, wobei die Display-Baugruppe dann auch die Funktion einer Arretiervorrichtung übernimmt, um die Verankerung zwischen Trägerteil und Montagerahmen fest zu arretieren.

Zur einfachen Montage unter schwierigen bzw. beengten Raumverhältnissen ist aus der DE 297 17 609 U1 eine Vorrichtung zum Befestigen von elektrischen oder elektronischen Bauteilen wie z.B. von Sensoren, Sendern oder Empfängern von Lichtschranken, Schaltern oder dergleichen an der Rückseite einer mit einer Bohrung versehenen Wandung, beispielsweise der Wandung eines Tür- oder Blendrahmenprofiles bekannt. Dabei sind ein Halteteil und ein keilförmiges Klemmstück vorgesehen, wobei das Halteteil aus einer Grundplatte mit einem Abdeckflansch sowie einer sich etwa lotrecht zur Grundplatte erstreckenden Halterung mit Mitteln zur Fixierung eines elektrischen oder elektronischen Bauteiles besteht. Die Halterung oder die Grundplatte ist mit mindestens einer für die Anlage des keilförmigen Klemmstückes bestimmten Hinterschneidung versehen, so dass das Halteteil unter Anlage seines Abdeckflansches an der Vorderseite an einer Wandung durch das auf der Rückseite der Wandung anliegende keilförmige Klemmstück an der Wandung festklemmbar ist. Die aneinanderliegenden Flanken der Hinterschneidungen einerseits und des keilförmigen Klemmstückes anderseits sind mit einer Verzahnung ausgestattet. Das Halteteil und das keilförmige Klemmstück sind aus Kunststoff hergestellt.

Weiterhin sind seit vielen Jahren/Jahrzehnten sogenannte Schnellverschlüße bekannt. Beispielsweise ist aus dem DE-GM 76 24 442.3 ein Schnellverschluß für Einschübe in sogenannte 19"-Schränke der Elektronik bekannt. Der Schnellverschluß besteht aus einem in ein Vierkantloch eines Flansch des 19"-Schranks (Flachmaterial) einsetzbaren Halter aus einem mehrfach gebogenen Federblechstreifen und einem in ein Rundloch der Abdeckplatte (Flachmaterial) des Einschubs einsetzbaren Kopfbolzen, dessen mit einem Querstift versehenes Schaftende durch ein diametral erweitertes Loch im Halter hindurchsteckbar und durch kurze Drehung mit den Querstiftenden über in Umfangsrichtung an die Locherweiterungen anschließende Rampen hinweg in Vertiefungen am dabei federnden Halter einrastbar ist. Im einzelnen ist vorgesehen, dass der Federblechstreifen im wesentlichen die Form eines in senkrechter Richtung gestauchten "S" aufweist, dessen oberer Schenkel flach ausgebildet und mit einer dem Vierkantloch des ersten Bauteils angepaßten und an gegenüberliegenden Seiten von Abkantungen zum Eingriff in das Vierkantloch begrenzten rechteckigen Durchbrechung versehen ist. Der mittlere Schenkel des Federblechstreifens weist eine beliebig ausgebildete Durchbrechung für den Durchtritt des Kopfbolzens auf und der untere Schenkel enthält das diametral erweiterte Loch mit den in Umfangsrichtung anschließenden Rampen und Vertiefungen.

Aus dem DE-GM 18 97 975 ist ein Gehäuse für elektrische Schaltgeräte bekannt, bei dem eine Frontplatte in längsliegenden Führungsnasen des Gehäuses liegt und durch symmetrisch angeordnete Verschlüsse gehalten wird. Jede Verschlußanordnung ist dabei so gestaltet, dass sie die Frontplatte in die Mitte des Gehäuses zieht. Da die Gehäuse im Umschlagverfahren gepresst werden, d.h. dass die Seitenwände einerseits und die Decke und der Boden andererseits gleichmässig geformt sind, werden die oberen und die unteren Führungsnasen gleich lang. Die Befestigung der Frontplatte kann infolgedessen nur in einer besonderen Art und Weise erfolgen. Die Frontplatte wird dazu in die untere Führungsnase bis auf den Grund derselben eingesetzt, um danach durch eine auf beiden Seiten vorhandene symmetrische Verschlußanordnung in die Mitte des Gehäuses gezogen zu werden. Die Frontplatte wird dadurch sowohl von der oberen als auch von der unteren Führungsnase gleichmässig gehalten und die Frontplatte in ihrer ganzen Länge fest an das Gehäuse angedrückt.

Die Frontplatten-Verschlußanordnungen, die symmetrisch auf die Vorderfronten der Seitenwände des Gehäuses verteilt sind, können sowohl Bajonettverschlüsse, Federrastverschlüsse als auch Schraubverschlüsse oder dgl. sein. Die Gegenstücke oder Verankerungen sitzen in den Vorderfronten der Seitenteile des Gehäuses und haben gemeinsam ein nach aussen gerichtetes konisches Loch, in das der Greifer oder die Schraube eingreift.

Schließlich ist aus dem DE-GM 17 00 201 eine Befestigung für einen durchsichtigen Deckel an einem gekapselten Gehäuse bekannt, wobei die Deckelbefestigung aus einem Schnellverschluß, z.B. nach Art des Bajonettverschlusses besteht. Alternativ kann der Schnellverschluß aus einem oder mehreren Schließbolzen mit Querstift und Isolierstoffkopf bestehen, die in je einer Buchse unter Zwischenschaltung einer Feder angeordnet sind und zusammen mit der Buchse unverlierbar im Rahmen befestigt sind, wobei die Buchse Scheibe und Rahmen durch einer Bund mittels der Federkraft zusammenhält.

Wie die vorstehende Würdigung des Standes der Technik aufzeigt, sind eine Vielzahl unterschiedlich ausgestalteter Befestigungsvorrichtungen, angepaßt für den jeweiligen Anwendungsfall bekannt. Dem Stand der Technik ist jedoch keine Anregung zu entnehmen, wie eine universell einsetzbare Befestigungsvorrichtung für verschiedenartige Anwendungsfälle ausgestaltet werden kann, mit der die Aufgaben einer raschen Montage und einstellbaren Ausrichtung, auch im Hinblick auf mehrfachen Ein- und Ausbau, technisch realisiert werden können.

Der Erfindung liegt daher die Aufgabe zugrunde, eine Befestigungsvorrichtung für ein elektronisches Gerät hinter einem Plattenausschnitt zu schaffen, die auch unter schwierigen bzw. beengten Raumverhältnissen eine einfache Montage/Demontage ermöglicht und welche eine Vielzahl von Einbau- und Montagemöglichkeiten bietet.

Diese Aufgabe wird, ausgehend von einer Befestigungsvorrichtung der eingangs erwähnten Art, dadurch gelöst, dass diese einen Schließzylinder mit einem Schließzylinder-Ansatz und eine am Tragrahmen als Gleitrinne, Falz oder Keilfläche ausgestaltete Kulisse aufweist, wobei durch Betätigung einer Schraube eine Schiebe und/oder Drehbewegung des Schließzylinders relativ zum Frontplatten-Ausschnitt bewirkt wird, derart, daß der Schließzylinder-Ansatz dabei gegen die Wandung des Frontplatten-Ausschnitts gedrückt wird.

Zwar ist die Benutzung von Klemmmitteln als Befestigungsvorrichtung an sich bekannt. So beschreibt die DE 42 31 827 A1 eine Klemmvorrichtung zum Festklemmen der Leiterplattenränder eines elektronischen Moduls in den seitlichen Führungsnuten eines Gehäuses, bei der die Führungsnuten auf der einen Seite durch eine feststehende Gehäuserippe und auf der anderen Seite durch drei längs der Gehäuserippe aneinandergereihte Keile begrenzt ist. Durch das Zusammenwirken der Schrägflächen eines feststehenden Endkeils, eines mittels einer Schraube in Richtung dieses Endkeils verschiebbaren Druckkeils und eines dazwischen angeordneten längs und quer verschiebbaren Spannkeiles sind die Leiterplattenränder zwischen Gehäuserippe und Spannkeil festklemmbar. Insbesondere sind alle drei Keile als Flachteile ausgebildet, wobei der Spannkeil über Nieten, die am Gehäuse befestigt und in schrägen Langlöchern des Spannkeiles geführt sind, auf der Oberfläche des Gehäuses flach aufliegend gehalten wird. Bei einer solchen Klemmvorrichtung besteht die Gefahr des Ausbrechens am Leiterplattenrand, so dass diese für einen mehrfachen Ein- und Ausbau nicht geeignet ist.

Die erfindungsgemäße Befestigungsvorrichtung weist demgegenüber den Vorteil auf, dass das Lösen und Auswechseln des Gerätes bzw. des Tragrahmens schnell und einfach möglich ist; zudem ist die Befestigungsvorrichtung kostengünstig herstellbar, unverlierbar und durch die Schiebe- und/oder Drehbewegung des Schließzylinders universell einsetzbar. Dadurch kann das elektronische Gerät, insbesondere die Anzeigevorrichtung, sowohl stationär in eine Schranktür oder eine Schalttafel als auch in ein becherartiges Transportgehäuse für den mobilen Einsatz eingebaut werden. Weiterhin ist von Vorteil, dass die Druckkraft (Aufpreßkraft, Klemmkraft) gegen die Wandung beim Betätigen der Schraube bzw. des Schließzylinders kontinuierlich erhöht werden kann. Dadurch, dass Gehäuse- und Schließzylinder aus dem gleichen Material gefertigt werden, ist die Gefahr der Beschädigung der Kulisse sicher vermieden. Weiterhin ist von Vorteil, dass die Kulisse konstruktiv einfach gestaltet ist, so dass der zusätzliche Kostenaufwand gering ist. Schließlich ist von Vorteil, dass auf überraschend einfache Art und Weise eine einfache und schnelle Montage auch unter beengten Platzverhältnissen ermöglicht wird, und dass die Montagearbeit keine speziellen Handfertigkeiten oder Vorkenntnisse erfordert.

Bei einer bevorzugten Ausgestaltung der Erfindung, gemäß Patentanspruch 2, wird bei manueller Betätigung der Schraube der Schließzylinder verschoben, wodurch der Schließzylinder-Ansatz auf der Kulisse aufgleitet und dabei gegen die Wandung des Frontplatten-Ausschnitts gedrückt wird.

Diese Ausgestaltung weist den Vorteil auf, dass keine scharfkantigen Übergangsstellen zwischen Schließzylinder-Ansatz und Kulisse auftreten, so dass tiefe Schleifspuren auch bei häufiger Schwenk- bzw. Schiebebewegung vermieden werden. Kulisse und Schließzylinder bestehen vorzugsweise aus dem gleichen Material.

In Weiterbildung der Erfindung nach Patentanspruch 3, weist die Schraube ein Linksgewinde auf.

Diese Weiterbildung weist die Vorteile auf, dass beliebig dicke Frontplatten benutzt werden können, dass der Anpreßdruck stufenlos und in einem weiten Bereich erhöht werden kann und dass ein genaues Ausrichten des Tragrahmens möglich ist, ohne dass eine aufwendige Montagearbeit hierfür erforderlich ist (lediglich Einschieben des Tragrahmens in den Frontplatten-Auschnitt), so dass gleichzeitig ein sicherer Sitz und eine einwandfreie Positionierung gewährleistet sind.

Gemäß Patentanspruch 4 ist vorgesehen, dass die Schraube einen Schraubendorn aufweist, welcher in einer Bohrung des Tragrahmens geführt ist.

Hierdurch wird eine fertigungstechnisch kostengünstige Führung bzw. Lagerung der Schraube bzw. des Schließzylinder erzielt. Weiterhin ist von Vorteil, dass bei der Montage die Schraube bzw. der Schließzylinder lediglich in die Bohrung eingeführt werden muß; zudem müssen keine engen Toleranzgrenzen eingehalten werden und die Schraube bzw. der Schließzylinder sind mit gewissem Spiel gelagert.

Weiterhin ist gemäß Patentanspruch 5 vorgesehen, dass der Schraubenkopf durch eine im Tragrahmen vorgesehene Durchführungsöffnung zugänglich ist.

Eine solche Ausgestaltung weist den Vorteil auf, dass auch ein Tragrahmen mit Gehäuserückwand benutzt werden kann und dass eine sichere Führung eines Schraubendrehers zur manuellen Betätigung des Schließzylinders bzw. des Schließzylinder-Ansatzes gewährleistet ist.

In weiterer Ausgestaltung der Erfindung gemäß Patentanspruch 6, ist der Schraubenkopf durch eine Befestigungsschraube, deren Schraubenachse im Winkel zum Schraubenkopf steht, seitlich am Tragrahmen gegen Kippen fixiert.

Diese Ausgestaltung weist den Vorteil auf, dass bei geringem konstruktiven Aufwand die Schraube leichtgängig geführt ist und dass bei der Montage außer einem Schraubendreher kein spezielles Werkzeug erforderlich ist. Gemäß Patentanspruch 7 weist der Schließzylinder-Ansatz eine Gleitfläche auf.

Hierdurch wird bei der Montage sichergestellt, dass Unebenheiten auf der Rückseite des Frontplatten-Ausschnitts nicht zu einer Schwergängigkeit beim Verschwenken des Schließzylinder-Ansatzes führen.

In Weiterbildung der Erfindung nach Patentanspruch 8, ist als Gleitfläche eine eingepresste Kugel vorgesehen.

Durch die Ausgestaltung der Gleitfläche in Form einer Kugel wird das Schwenken des Schließzylinder-Ansatzes erleichtert und gleichzeitig werden Schleifspuren auf der Rückseite des Frontplatten-Ausschnitts vermieden.

Schließlich ist gemäß Patentanspruch 9 vorgesehen, dass der Schließzylinder-Ansatz bei manueller Betätigung auf der Kulisse aufgleitet und dabei gegen die Seitenwand des becherartigen Gehäuses gedrückt wird.

Diese Ausgestaltungen der erfindungsgemäßen Befestigungsanordnung weisen den Vorteil auf, dass ergänzend oder alternativ auch eine Festlegung des Tragrahmens an der Seitenwand im Transportgehäuse erfolgen kann. Zudem ist von Vorteil, dass der Montageaufwand sich auf einfache Handgriffe beschränkt. Fertigungstechnisch erfordert diese Ausgestaltung einen geringen Aufwand.

Weitere Vorteile und Einzelheiten lassen sich der nachfolgenden Beschreibung einer bevorzugten Ausführungsformen der Erfindung unter Bezugnahme auf die Zeichnung entnehmen. In der Zeichnung zeigt:
- FIG. 1: eine Seitenansicht der erfindungsgemäßen Befestigungsvorrichtung,
- FIG. 2: eine Teilansicht der erfindungsgemäßen Befestigungsvorrichtung mit Tragrahmen und Blende teilweise im Schnitt,
- FIG. 3: Tragrahmen und erfindungsgemäße Befestigungsvorrichtung in Draufsicht,
- FIG. 4: eine Ausführungsform des Schließzylinders in Draufsicht und
- FIG. 5: eine Seitenansicht des Schließzylinders nach FIG. 4,
- FIG. 6 und 7: Einzelheiten der Anordnung der erfindungsgemäßen Befestigungsvorrichtung am Tragrahmen in Seitenansicht und
- FIG. 8: den Tragrahmen mit Schaltungsplatine in Draufsicht.

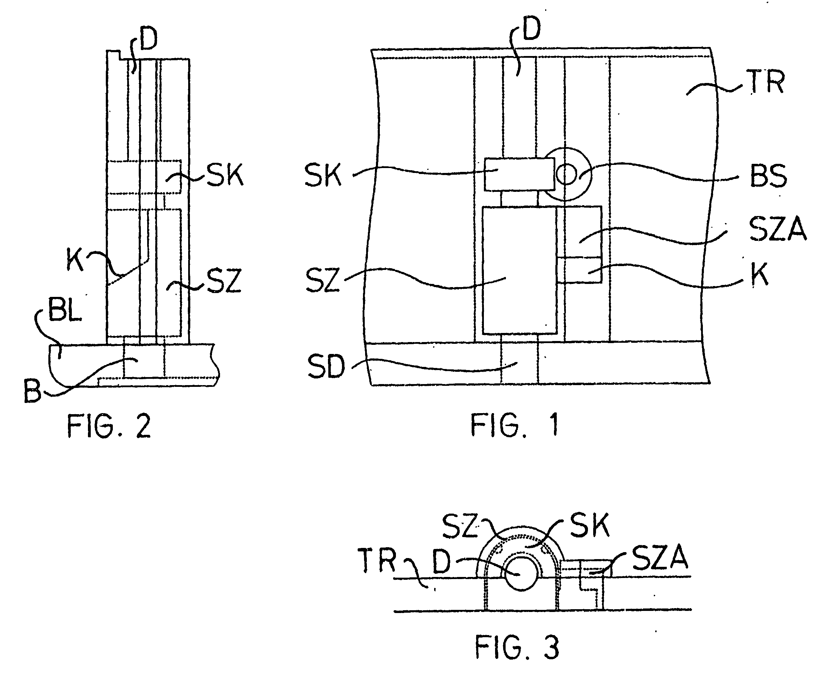

Die erfindungsgemäße Befestigungsvorrichtung wird im folgenden für den Anwendungsfall bei einem Datenanzeigegerät mit einem Display, anhand der FIG. 1 bis 8 näher beschrieben und erläutert.

Erfindungsgemäß weist die Befestigungsvorrichtung BV einen Schließzylinder SZ mit einem Schließzylinder-Ansatz SZA und eine Kulisse K auf (FIG. 1 bis FIG. 3). Bei der in der Zeichnung dargestellten Ausführungsform ist die Kulisse am Tragrahmen TR als Keilfläche K ausgestaltet und zur manuellen Betätigung des Schließzylinders SZ ist eine Schraube S mit einem Linksgewinde vorgesehen, welche den Schließzylinder SZ verschiebt. Im einzelnen weist die Schraube S einen Schraubendorn SD auf, welcher in einer Bohrung B des Tragrahmens TR geführt ist. Der Schraubenkopf SK ist durch eine im Tragrahmen TR vorgesehene Durchführungsöffnung D zugänglich und durch eine Befestigungsschraube BS seitlich am Tragrahmen TR gegen Kippen fixiert.

Zur Befestigung des elektronischen Geräts im Frontplatten-Ausschnitt einer in den Zeichnungen nicht dargestellten Schalttafel, wird dessen Tragrahmen in den Ausschnitt eingeschoben, bis die Blende BL gegen die Vorderseite des Frontplatten-Ausschnittes stößt. Bei manueller Betätigung, d.h. drehen der Schraube S mittels in die Durchführungsöffnung eingebrachten Schraubendreher, gleitet der Schließzylinder-Ansatz SZA auf der Keilfläche K auf und wird dabei gegen die Wandung des Frontplatten-Ausschnitts gedrückt. Da die Schraube S ein Linksgewinde aufweist, erfolgt beim Rechtsdrehen (im Uhrzeigersinn), wie gewohnt, die Befestigung des Tragrahmens TR.

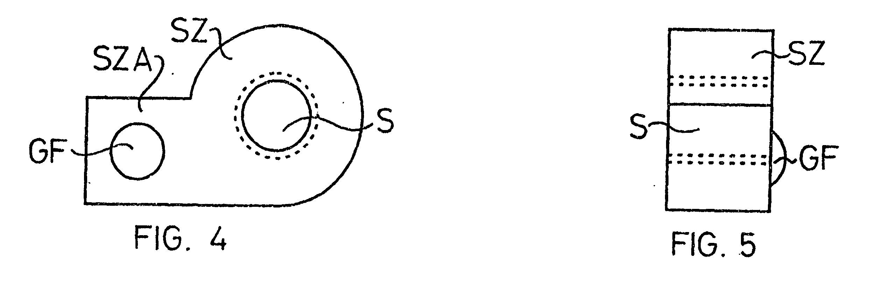

Bei der in den FIG. 4 und 5 dargestellten Ausführungsform weist der Schließzylinder-Ansatz SZA eine Gleitfläche GF in Form einer in den Schließzylinder-Ansatz SZA eingepressten Kugel auf. Vor dem Einschieben des Tragrahmens TR in den Frontplatten-Ausschnitts müssen der Schließzylinder SZ bzw. der Schließzylinder-Ansatz SZA eingeschwenkt sein. Falls der Reibschluß zwischen Gewinde und Schließzylinder SZ nicht ausreicht, um beim Linksdrehen der Schraube S den Schließzylinder-Ansatz SZA automatisch in die Ausgangslage zurückzuschwenken, kann der Schließzylinder SZ bzw. der Schließzylinder-Ansatz SZA gegen die Wandung (mit Profil) des Tragrahmens TR festgedreht werden.

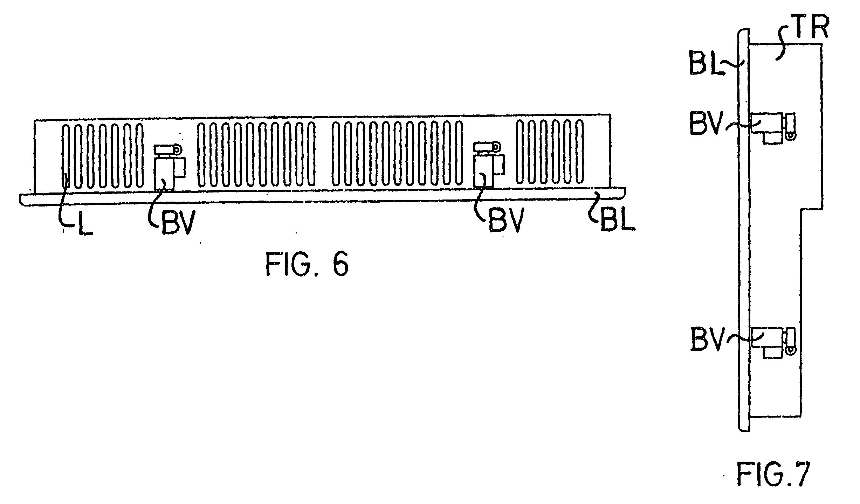

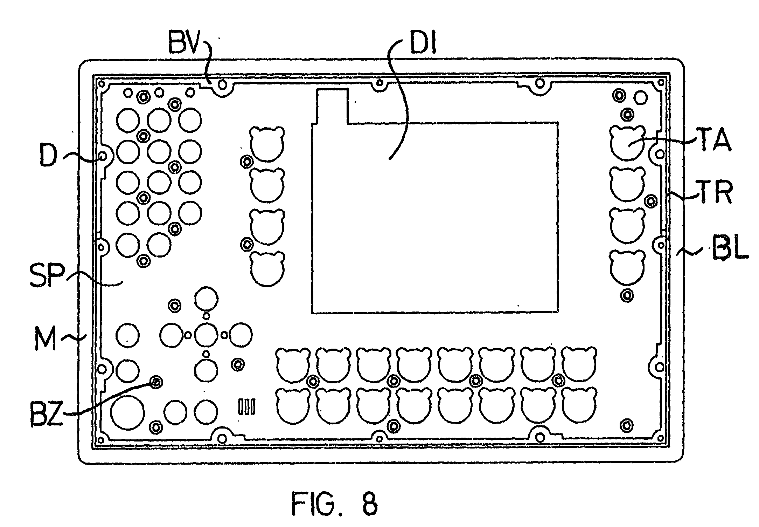

Wie aus den FIG. 6 bis 8 ersichtlich ist, sind am Umfang des Tragrahmens TR insgesamt acht Befestigungsanordnungen BV vorgesehen. Der Tragrahmen TR weist am Umfang verteilt Lüftungsschlitze L zum seitlichen Abzug der Wärme auf (siehe FIG. 6). Um einen dichten Abschluß zwischen Blende BL und Frontplatten-Ausschnitt zu ermöglichen, kann eine Moosgummi-Dichtung M vorgesehen werden. Einzelheiten einer im Tragrahmen aufgenommenen Schaltungsplatine SP, insbesondere Anordnung von Bolzen BZ, Tasten-Ausbrüchen TA und Display DI zeigt FIG. 8.

Bei einer in der Zeichnung nicht dargestellten Ausführungsform gleitet der Schließzylinder-Ansatz SZA bei manueller Betätigung auf der Kulisse K derart auf, dass dieser dabei gegen die Seitenwand eines becherartigen Gehäuses, welches den Tragrahmen TR auf der Rückseite umfaßt, gedrückt wird.

Die Erfindung ist nicht auf das dargestellte Ausführungsbeispiel beschränkt. Es ist beispielsweise im Rahmen der Erfindung denkbar, anstelle der Befestigungsschraube zur Führung des Schraubenkopfs einen Lappen aus der Wandung des Tragrahmens auszureißen; anstelle des Schraubendorns ein Gewinde bzw. eine Mutter in der Blende vorzusehen usw.

Allen diesen Ausgestaltungen der erfindungsgemäßen Befestigungsvorrichtung ist das schnelle und einfache Lösen und Auswechseln des Gerätes bzw. des Tragrahmens gemeinsam; zudem ist die Befestigungsvorrichtung kostengünstig herstellbar und universell einsetzbar. Dadurch können die besonderen Anforderungen, insbesondere hinsichtlich Flexibilität und Wirtschaftlichkeit für die verschiedenen Konstruktionen erfüllt werden.

Alle dargestellten und beschriebenen Ausführungsmöglichkeiten, sowie alle in der Beschreibung und/oder der Zeichnung offenbarten neuen Einzelmerkmale und ihre Kombination untereinander, sind erfindungswesentlich. Beispielsweise kann durch die Betätigung der Schraube zusätzlich eine Feder / ein Federgelenk gegen die Wandung des Frontplatten-Ausschnitts/Bechergehäuses gedrückt werden, die Unverlierbarkeit der Befestigungsvorrichtung durch eine seitliche Abdeckung oder eine am Schraubenkopf / Schließzylinder seitlich anliegende Blattfeder sichergestellt werden usw.

## Patentansprüche

1. Befestigungsvorrichtung für ein elektronisches Gerät oder dessen Tragrahmen (TR) in einem Frontplatten-Ausschnitt einer Schalttafel oder eines Gehäuses, welche aufweist
a) einen Schließzylinder (SZ) mit einem Schließzylinder-Ansatz (SZA)
b) eine am Tragrahmen (TR) als Gleitrinne, Falz oder Keilfläche ausgestaltete Kulisse (K),
wobei durch Betätigung einer Schraube (S) eine Schiebe- und/oder Drehbewegung des Schließzylinders (SZ) relativ zum Frontplatten-Ausschnitt bewirkt wird, derart, daß der Schließzylinder-Ansatz dabei gegen die Wandung des Frontplatten-Ausschnitts gedrückt wird.

2. Befestigungsvorrichtung nach Anspruch 1, **dadurch gekennzeichnet, dass** bei manueller Betätigung der Schraube (S) der Schließzylinder (SZ) verschoben wird, wodurch der Schließzylinder-Ansatz (SZA) auf der Kulisse (K) aufgleitet und dabei gegen die Wandung des Frontplatten-Ausschnitts gedrückt wird.

3. Befestigungsvorrichtung nach Anspruch 1, **dadurch gekennzeichnet, dass** die Schraube (S) ein Linksgewinde aufweist.

4. Befestigungsvorrichtung nach Anspruch 3, **dadurch gekennzeichnet, dass** die Schraube (S) einen Schraubendorn (SD) aufweist, welcher in einer Bohrung (B) des Tragrahmens (TR) geführt ist.

5. Befestigungsvorrichtung nach Anspruch 3, **dadurch gekennzeichnet, dass** der Schraubenkopf (SK) durch eine im Tragrahmen (TR) vorgesehene Durchführungsöffnung (D) zugänglich ist.

6. Befestigungsvorrichtung nach Anspruch 3, **dadurch gekennzeichnet, dass** der Schraubenkopf (SK) durch eine Befestigungsschraube (BS), deren Schraubenachse im Winkel zum Schraubenkopf (SK) steht, seitlich am Tragrahmen (TR) gegen Kippen fixiert ist.

7. Befestigungsvorrichtung nach Anspruch 1, **dadurch gekennzeichnet, dass** der Schließzylinder-Ansatz (SZA) eine Gleitfläche (GF) aufweist.

8. Befestigungsvorrichtung nach Anspruch 7, **dadurch gekennzeichnet, dass** als Gleitfläche (GF) eine eingepresste Kugel vorgesehen ist.

9. Befestigungsvorrichtung nach Anspruch 1, **dadurch gekennzeichnet, dass** der Schließzylinder-Ansatz (SZA) bei manueller Betätigung auf der Kulisse (K) aufgleitet und dabei gegen die Seitenwand des becherartigen Gehäuses gedrückt wird.

## Claims

1. A fastening device for an electronic apparatus or its supporting frame (TR) in a front plate opening of a control panel or in a casing providing
a) a clamping cylinder (SZ) with a clamping cylinder nose (SZA),
b) a link (K) formed on the supporting frame (TR) as sliding groove, turn-up or wedge-shaped surface,
and when operating a screw (S) a sliding and/or turning movement of the clamping cylinder (SZ) is achieved in relation to the front plate opening in such a way, that the clamping cylinder nose (SZA) is pressed against the wall of the front plate opening.

2. The fastening device of claim 1, wherein said screw (S) moves the clamping cylinder (SZ) when being manually operated and the clamping cylinder nose (SZA) slides onto the link (K) and is pressed against the front plate opening.

3. The fastening device of claim 1, wherein said screw (S) provides a left-hand thread.

4. The fastening device of claim 3, wherein said screw (S) provides a screw pin (SD), which is guided in a drilling (B) of the supporting frame (TR).

5. The fastening device of claim 3, wherein said screw head (SK) is accessible through a lead-through opening (D) in the supporting frame (TR).

6. The fastening device of claim 3, wherein said screw head (SK) is laterally fixed on the supporting frame (TR) by means of a mounting screw (BS), the axle of which runs crossways in relation to the screw head, thus being protected against tilting.

7. The fastening device of claim 1, wherein clamping cylinder nose (SZA) provides a sliding surface (GF).

8. The fastening device of claim 7, wherein said sliding surface (GF) is provided in form of a pressed-in bowl.

9. The fastening device of claim 1, wherein said clamping cylinder nose (SZA) slides onto the link (K) and is pressed against the side wall of the bowl-shaped casing when being manually operated.

## Revendications

1. Dispositif de fixation d'un appareil électronique, ou son cadre support (TR) dans l'ouverture d'une façade d'un tableau de commande ou d'un boîtier qu'il comprend
c) un cylindre de fermeture (SZ) avec un appendice de cylindre de fermeture (SZA)
d) une coulisse (K) étant placée au cadre support (TR) et étant formée comme guidage à glissement, pli ou rainure à clavette,
où par actionnement d'une vis (S) un mouvement rotatif et/ou de translation du cylindre de fermeture (SZ) est provoqué par rapport de l'encoche de la platine avant de telle manière que l'appendice du cylindre de fermeture (SZA) est pressé contre la paroi de l'encoche de l'ouverture d'une façade.

2. Dispositif de fixation selon revendication 1, **caractérisé en ce que** le cylindre de fermeture (SZ) est déplacé en actionnant manuellement la vis (S) par lequel l'appendice de cylindre de fermeture (SZA) glisse sur la coulisse (K) et est poussé contre la paroi de l'encoche de l'ouverture d'une façade.

3. Dispositif de fixation selon revendication 1, **caractérisé en ce que** la vis (S) possède un filetage à gauche.

4. Dispositif de fixation selon revendication 3, **caractérisé en ce que** la vis (S) possède un bout étant dégagé (SD), lequel est guidé dans un trou (B) du cadre support (TR).

5. Dispositif de fixation selon revendication 3, **caractérisé en ce que** la tête de vis (SK) est accessible par une ouverture (D) dans le cadre support (TR).

6. Dispositif de fixation selon revendication3, **caractérisé en ce que** la tête de vis (SK) est fixée latéralement au cadre support (TR) par une vis de fixation (BS) dont son axe forme un angle avec la tête de vis (SK), contre un basculement.

7. Dispositif de fixation selon revendication 1, **caractérisé en ce que** l'appendice de cylindre de fermeture (SZA) a une surface de glissement (GF).

8. Dispositif de fixation selon revendication 7, **caractérisé en ce qu'**on a enfoncé une boule dans la surface de glissement (GF).

9. Dispositif de fixation selon revendication 1, **caractérisé en ce que** l'appendice du cylindre de fermeture (SZA) glisse sur la coulisse (K) étant actionné manuellement et il est pressé en même temps contre la paroi du boîtier en forme de gobelet.
